# EUROPEAN PATENT APPLICATION

(11) **EP 2 015 088 A1**
(43) Date of publication of application: **14.01.2009**
(21) Application number: 08160096.7
(22) Date of filing: 10.07.2008
(51) Int. Cl.: G01R 31/28, G01R 1/073, H01B 5/16

(54) **Method of positioning an anisotropic conductive connector, method of positioning the anisotropic conductive connector and a circuit board for inspection, anisotropic conductive connector and probe card**

(30) Priority: 11.07.2007 JP 2007182357
(71) Applicant: JSR Corporation, Tokyo 104-8410 (JP); Tokyo Electron Limited, Tokyo 107-6325 (JP)
(72) Inventor: Yoshioka, Mutsuhiko, Chuo-ku Hyogo 104-0045 (JP); Matsuura, Akira, Chuo-ku Tokyo 104-0045 (JP); Naoi, Masaya, Chuo-ku Tokyo 104-0045 (JP); Amemiya, Takashi, Nirasaki-shi Yamanashi 407-8511 (JP); Tsukada, Syuichi, Nirasaki-shi Yamanashi 407-8511 (JP); Hoshino, Tomohisa, Amagasaki-shi Hyogo 660-0891 (JP)
(74) Representative: TBK-Patent

(57) **Abstract**

[Object]

Provided is a method for positioning an anisotropic conductive connector, which method can conduct positioning of each component of a three-layered rectangular frame-like anisotropic conductive connector completely and easily.

[Means for solving]

The method is a method for positioning a three-layered rectangular frame-like anisotropic conductive connector in order to inspect the electrical properties of an object for inspection. The positioning is carried out in the following manner. The three-layered anisotropic conductive sheet is composed of a first anisotropic conductive sheet 18, a center substrate 16 and a second anisotropic conductive sheet 20. Markings 76 and 77, and through-holes 74, 75 are formed on the center substrate 16, and semi-transparent protrusions 71, 72, 49 and 78, and through-holes 70 and 80 are formed on each of the first anisotropic conductive sheet 18 and the second anisotropic conductive sheet 20. The markings 76 and 77 are identified through the semi-transparent protrusions 71 and 49 by a detecting means 81 and 83 disposed on the side of the first anisotropic conductive sheet 18 and a detecting means 82 disposed on the side of the second anisotropic conductive sheet 20 and thereby the positioning of the semi-transparent protrusions 71 and 49 to the markings 76 and 77 is carried out, whereby performing the positioning of the first anisotropic conductive sheet 18, the center substrate 16 and the second anisotropic conductive sheet 20.

## Description

The present invention relates to a method of positioning an anisotropic conductive connector which is used suitably as a connector for an electrical connection between circuit devices such as an electronic component or an inspection apparatus of a printed wiring board, a method of positioning the anisotropic conductive connector and a circuit board for inspection, an anisotropic conductive connector, and a probe card.

### BACKGROUND ART

As an anisotropic conductive sheet, there are known those having a pressurizing conducting portion exhibiting conductivity in only a thickness direction or exhibiting conductivity in only the thickness direction when a pressure is applied in a thickness direction. These anisotropic conductive sheets have such properties that a compact electrical connection can be effected without using a means such as soldering or mechanical fitting and a soft connection can be made while absorbing mechanical impact and distortion when a sheet material is an elastic one such as elastomers.

Therefore, the anisotropic conductive sheets are widely used as a connector for making an electrical mutual connection between circuit devices such as a printed circuit board and a lead less chip carrier or a liquid crystal panel in the fields of electronic calculators, electronic digital clocks, electronic cameras, and computer keyboards by utilizing such properties.

In electrical inspection of a circuit board such as a printed board, an anisotropic conductive sheet is disposed as a connector between an electrode area to be inspected in a circuit board and an electrode area for connection in a circuit board for inspection in order to make an electrical connection between an electrode to be inspected, which is formed on the surface of the circuit board to be inspected and an electrode for connection, which is formed on the surface of the circuit board for inspection.

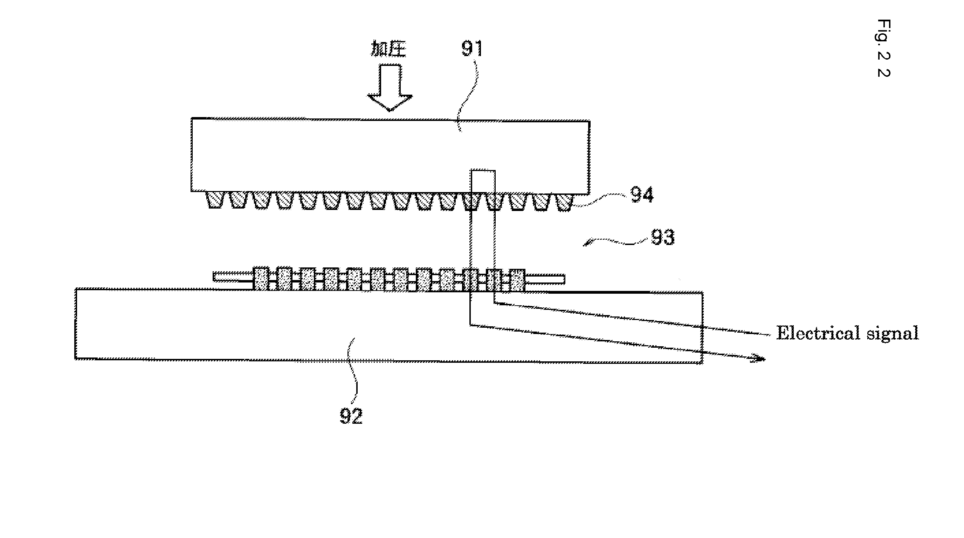

For instance, as shown in Fig. 22, an anisotropic conductive connector 93 is disposed between a circuit board 91, which is an object of inspection, and a circuit board 92 for inspection, and by applying a pressure to the circuit board 91, the circuit board 91 is abutted to the anisotropic conductive connector 93. In this state, an electrical signal is supplied to the circuit board 92 for inspection, and is sent from an electrode for inspection of the circuit board 92 to the anisotropic conductive connector 93 and an electrode 94 of the circuit board 91. Thereafter, the electrical signal is returned again to the circuit board 92 through the anisotropic conductive connector 93, thereby detecting a circuit of the circuit board 91.

As an anisotropic conductive sheet used for such electrical inspection, those having various structures are known. For example, Patent Document 1 (JP-A-51(1976)-93393 discloses an anisotropic conductive sheet obtained by uniformly dispersing metal particles in an elastomer (which will be hereinafter referred to as a "dispersion type anisotropic conductive sheet"). Moreover, Patent Document 2 (JP-A-53(1978)-147772) discloses an anisotropic conductive sheet obtainable by unevenly distributing conductive magnetic particles into an elastomer, thereby forming a large number of conducting path forming portions extended in a thickness direction and insulating portions for mutually insulating them (hereinafter referred to "uneven distribution type anisotropic conductive sheet"). Furthermore, Patent Document 3 (JP-A-61(1986)-250906) discloses an uneven distribution type anisotropic conductive sheet that a difference in level is formed between the surface of a conductive path-forming portion and an insulating portion.

Furthermore, Patent Document 4 (JP-A-2005-201892) discloses an uneven distribution type anisotropic conductive sheet which peripheral portion is supported by a support made of a metal or the like.
In the uneven distribution type anisotropic conductive sheet, a conducting path-forming portion is formed according to an electrode pattern of a circuit board and an objective pattern. Consequently, the uneven distribution type anisotropic conductive sheet can advantageously make an electrical connection between electrodes with high reliability for a circuit board in which electrodes for connection are disposed at a small pitch.

In recent years, minimization and high densification of electrode dimensions and dimensions between electrodes are progressed for surface mounting LSI's and electronic circuit boards. Corresponding to the progress, minimization of a conducting portion or the like is required for an anisotropic conductive sheet. As such minimization is progressed, a ratio in area of an elastic portion to a conducting portion is decreased in an anisotropic conductive sheet. Consequently, the load per an area supported by an elastic portion to distortion is increased, and thereby the elasticity is lowered.

A bump form of an electronic circuit board, which is contact with an anisotropic conductive sheet has dispersion in a height direction to a certain degree. Consequently, since a high distortion is partially applied to some bump forms, an anisotropic conductive sheet preferably has elasticity capable of sufficiently absorbing dispersion in height of bump forms.

Moreover, a conventional uneven distribution type anisotropic conductive sheet is formed flexibly by using silicon rubber or the like as a base material. A circuit board or a semiconductor device, which is connected to the uneven distribution type anisotropic conductive sheet, is formed by using a glass fiber containing epoxy resin, a metal plate made of copper or the like, or a material having rigidity in a certain degree such as silicon. Consequently, in aligning a flexible anisotropic conductive sheet to an object accurately, the electrode positions of the both matters are shifted by temperature change since the hardness and thermal expansion coefficient are different in the both matters. Therefore, an electrical conduction cannot be maded occasionally. Such a problem is remarkable as a pitch between electrodes is smaller and an electrode pattern is miniaturized.

In order to solve such a problem, the present applicant discloses laminates having a three-layered structure in Patent Document 5 (Fig. 8 of JP-A-10(1998)-200242), Patent Document 6 (Fig. 1 of JP-A-11(1999)-273772), and Patent Document 7 (JP-A-2004-227828). Specifically, as described in Patent Documents 5, 6, and 7, the anisotropic conductive rubber sheets made of an elastic material are disposed on the both surfaces, and a circuit board having suitable rigidity and electrical conduction as an intermediate layer is disposed between the anisotropic conductive rubber sheets.
Patent Document 1: JP-A-51(1976)-93393
Patent Document 2: JP-A-53(1978)-147772
Patent Document 3: JP-A-61(1986)-250906
Patent Document 4: JP-A-2005-201892
Patent Document 5: JP-A-10(1998)-200242
Patent Document 6: JP-A-11(1999)-273772
Patent Document 7: JP-A-2004-227828

### DISCLOSURE OF THE INVENTION PROBLEMS TO BE SOLVED BY THE INVENTION

Even in the anisotropic conductive connector having a three-layered structure with a comparatively hard intermediate layer, the positioning of the first to third layers must be carried out accurately. If the positioning is not carried out accurately, an electrical inspection of a wafer, which is an object of inspection, cannot be carried out accurately. Moreover, it is required to produce the anisotropic conductive connector at lower cost.

Under the circumstances, it is an object of the present invention to provide a method of positioning an anisotropic conductive sheet, particularly a method capable of positioning a flexible anisotropic conductive sheet, reliably and easily to an object at low cost.

Moreover, it is another object of the present invention to provide a method of positioning an anisotropic conductive connector, particularly a method capable of positioning each sheet reliably and easily even in the anisotropic conductive connector having a three-layered structure.

It is a further object of the present invention to provide a method of positioning the anisotropic conductive connector and a circuit board for inspection, particularly a method capable of positioning the anisotropic conductive connector having a three-layered structure and a circuit board for inspection reliably and easily.

Moreover, it is an object of the present invention to provide an anisotropic conductive connector having a three-layered structure which can be manufactured at low cost and which can be positioned with a circuit board such as a wafer to be inspected or with a circuit board for inspection accurately because an electrode position is hardly shifted.

Moreover, it is an object of the present invention to provide a probe card formed using an anisotropic conductive connector in which a conducting portion of an anisotropic conductive sheet and an electrode of a center substrate are accurately positioned and capable of inspecting a fine and dense object accurately.

### MEANS FOR SOLVING THE OBJECTS

In positioning a flexible anisotropic conductive sheet to an object, the method for positioning an anisotropic conductive sheet according to the present invention comprises the steps of:
forming a semi-transparent protrusion on the anisotropic conductive sheet and also
forming a marking on an object,
identifying the marking through the semi-transparent protrusion formed on the anisotropic conductive sheet and thereby
positioning the anisotropic conductive sheet to the object.

Such a positioning method can perform accurate positioning of a flexible anisotropic conductive sheet to an object.
In positioning a flexible anisotropic conductive sheet to an object, it is also possible in the present invention to position the anisotropic conductive sheet to the object by forming a semi-transparent protrusion on the anisotropic conductive sheet and also forming a through-hole on the object, identifying the through-hole through the semi-transparent protrusion formed on the anisotropic conductive sheet.

In positioning a flexible anisotropic conductive sheet to an object, it is further possible in the present invention to position the anisotropic conductive sheet to the object by forming at least two semi-transparent protrusions on the anisotropic conductive sheet and also forming at least one marking and at least one through-hole on the object, identifying the marking through the one semi-transparent protrusion formed on the anisotropic conductive sheet and also identifying the through-hole through the other one semi-transparent protrusion.

The above positioning methods can perform positioning of a flexible anisotropic conductive sheet to an object accurately and easily.
Moreover, in the present invention, a non-transparent mark for alignment is previously formed in the periphery of the semi-transparent protrusion formed on the anisotropic conductive sheet. The positioning of the anisotropic conductive sheet and the object is conducted, at first, by approaching the mark for alignment to the marking formed on the object, and then aligning the semi-transparent protrusion to the marking center and thereby conducting fine adjustment for positioning.

Furthermore, in the present invention, a non-transparent mark for alignment is previously formed in the periphery of the semi-transparent protrusion formed on the anisotropic conductive sheet. The positioning of the anisotropic conductive sheet and the object is conducted by, at first, approaching the mark for alignment to the through-hole formed on the object, and then aligning the semi-transparent protrusion to the through-hole center and thereby conducting fine adjustment for positioning.

In the present invention, further, a non-transparent mark for alignment is previously formed in the periphery of the two semi-transparent protrusions formed on the anisotropic conductive sheet. The positioning of the anisotropic conductive sheet and the object is conducted by, at first, approaching the mark for alignment formed in the periphery of the one semi-transparent protrusion to the marking formed on the object and also approaching the mark for alignment formed in the periphery of the other semi-transparent protrusion to the through-hole, and then aligning the one semi-transparent protrusion to the marking center and also aligning the other one semi-transparent protrusion to the through-hole center, and thereby conducting fine adjustment for positioning.

As described above, forming the non-transparent mark for alignment in the periphery of the semi-transparent protrusion formed on the anisotropic conductive sheet previously, the semi-transparent protrusion formed on the anisotropic conductive sheet is exhibited visually so that the semi-transparent protrusion can be found out easily. As a result, it is possible to carrying out positioning more quickly.

It is preferable in the present invention that the marking is simultaneously formed on the object in a process of forming a circuit on the object. Furthermore, it is preferable in the present invention that the through-hole is simultaneously formed on the object in a process of forming a circuit on the object.

In the present invention, the semi-transparent protrusion disposed on the anisotropic conductive sheet is preferably formed simultaneously in a process of injecting a molding material containing conductive particles having magnetic properties into a molding space of a mold and thereby forming a molding material layer, and conducting hardening treatment by application of a magnetic field.

In the above manner, the marking, the rough-hole and the semi-transparent protrusion can be formed at low cost.
The positioning of the anisotropic conductive sheet and the object may be conducted on two sides which are parallel each other in the present invention.

If the positioning is conducted on at least two sides in the above manner, the positioning of the anisotropic conductive sheet to the object can be conducted accurately.
Furthermore, in the present invention, the positioning of the anisotropic conductive sheet and the object is preferably conducted on two sets of two sides which are parallel each other.

If the positioning is conducted on two sets of two sides which are parallel each other in the above manner, the positioning can be conducted more accurately.
The object of the present invention may be a hard center substrate.

If the object for positioning of the present invention may be a hard center substrate, it can be suitably used for constituting a three-layered anisotropic conductive connector.
The method for positioning an anisotropic conductive sheet according to the present invention is a method for positioning an anisotropic conductive connecter obtainable by disposing a first anisotropic conductive sheet, a center substrate and a second anisotropic conductive sheet in this order. The method comprises the steps of:
forming a semi-transparent protrusion on each of the first anisotropic conductive sheet and the second anisotropic conductive sheet,
   forming a marking on each of the upper and lower surfaces of the center substrate,
identifying the markings formed on the center substrate through the semi-transparent protrusions formed on the first and second anisotropic conductive sheets from the both sides of the substrate by a detecting means disposed on the first anisotropic conductive sheet side and a detecting means disposed on the second anisotropic conductive sheet side, and thereby
conducting positioning of the first anisotropic conductive sheet, the center substrate and the second anisotropic conductive sheet.

According to the positioning method, the three layers of the first anisotropic conductive sheet, the center substrate and the second anisotropic conductive sheet can be positioned accurately.
In the method for positioning an anisotropic conductive connecter according to the present invention which further comprises forming a non-transparent mark for alignment in the periphery of the semi-transparent protrusion formed on each of the first and second anisotropic conductive sheets respectively, the identification of the markings formed on the upper and lower surfaces of the center substrate through the semi-transparent protrusion of the first anisotropic conductive sheet and the semi-transparent protrusion of the second anisotropic conductive sheet is conducted by, at first, identifying that the non-transparent marks for alignment are set to be opposite to the markings and then aligning the semi-transparent protrusions to the marking centers and thereby conducting fine adjustment for positioning.

If the constitution is as described above, the semi-transparent protrusions formed on the first and second anisotropic conductive sheets are exhibited visually so that the semi-transparent protrusions can be found out easily. As a result, it is possible to carrying out alignment more quickly.

In the method for positioning an anisotropic conductive connecter according to the present invention, the positioning of the first anisotropic conductive sheets, the center substrate and the second anisotropic conductive sheets is preferably conducted on two sides which are parallel each other.

If the positioning is conducted on at least two sides, it is possible to perform the positioning accurately.
In the method for positioning an anisotropic conductive connecter according to the present invention, the positioning of the first anisotropic conductive sheets, the center substrate and the second anisotropic conductive sheets can be also conducted on two sets of two sides which are parallel each other.

If the positioning is conducted on four sides as described above, it is possible to perform the positioning of the anisotropic conductive sheet on which a conductive part is formed at a fine pitch densely, and the object more precisely.
In the present invention, at least two semi-transparent protrusions and at least one through-hole are formed in each of four sides of the first anisotropic conductive sheet and in each of four sides of the second anisotropic conductive sheet, respectively and at least two through-holes are formed in each of four sides of the center substrate and at least one marking is formed on each of the upper and lower surfaces of the center substrate.
The positioning of the first anisotropic conductive sheet and the center substrate is preferably conducted by aligning one semi-transparent protrusion formed on the first anisotropic conductive sheet to the one through-hole formed on the center substrate and also aligning the other one semi-transparent protrusion formed on the first anisotropic conductive sheet to the upper surface marking formed on the center substrate, and the positioning of the second anisotropic conductive sheet and the center substrate is preferably conducted by aligning the one semi-transparent protrusion formed on the second anisotropic conductive sheet to the one through-hole formed on the center substrate and also aligning the other one semi-transparent protrusion formed on the second anisotropic conductive sheet to the lower surface marking formed on the center substrate.

If the positioning is conducted in the above manner, it is possible to perform the position utilizing the shape of the marking, the shape of the semi-transparent protrusion and the shape of the through-hole effectively.
In positioning, on a circuit board for inspection, a rectangular anisotropic conductive connector having a three-layered structure obtainable by forming a first anisotropic conductive sheet having at least two semi-transparent protrusions and at least one through-hole formed on each side of four sides of a rectangular frame-like portion, a second anisotropic conductive sheet having at least two semi-transparent protrusions and at least one through-hole formed on each side of four sides of a rectangular frame-like portion, a center substrate having at least two through-holes formed on each side of four sides of a rectangular frame-like part and at least one marking formed on each of the upper and lower surfaces in one piece,
the method comprises the steps of:
forming at least two markings on each side of four sides of a rectangular frame-like portion of the circuit board for inspection,
aligning the one semi-transparent protrusion of either of the first anisotropic conductive sheet and the second anisotropic conductive sheet, which protrusion corresponds to the one through-hole on one side of the four sides of the center substrate, to the one marking of the circuit board for inspection,
aligning the other semi-transparent protrusion of either of the first anisotropic conductive sheet and the second anisotropic conductive sheet, which protrusion corresponds to the other one through-hole on one side of the four sides of the center substrate, to the other one marking of the circuit board for inspection and thereby
conducting positioning on each side of the four sides respectively.

According to such a method, after the circuit board for inspection is superimposed on the anisotropic conductive connector having a three-layered structure assembled in one piece, the positioning thereof can be easily detected by a detecting means.
The anisotropic conductive connector of the present invention has a rectangular frame-like three-layered structure obtainable by disposing a first anisotropic conductive sheet having a semi-transparent protrusion and a through-hole, a center substrate having a marking and a though-hole and a second anisotropic conductive sheet having a semi-transparent protrusion and a through-hole, in this order,
wherein the semi-transparent protrusion of the first anisotropic conductive sheet and the marking of the center substrate are aligned, the semi-transparent protrusion of the second anisotropic conductive sheet and the marking are aligned, and thereby the positioning of the center substrate, the first anisotropic conductive sheet and the second anisotropic conductive sheet is conducted.

In the anisotropic conductive connector as described above, the positioning of the three layers can be performed accurately.
In the anisotropic conductive connector according to the present invention, the semi-transparent protrusions provided on the first and second anisotropic conductive sheets are formed simultaneously in a process of forming a molding material layer by injecting a molding material containing conductive particles having magnetic properties into a molding space of a mold and conducting hardening treatment by application of a magnetic field.

Such an anisotropic conductive connector can be produced at small lost because the semi-transparent protrusions can be formed simultaneously when the uneven conductive portion is formed by the conductive particles.

The markings and the through-holes formed on the center substrate are preferably formed simultaneously in a process of forming the circuit on the center substrate.
The anisotropic conductive connector can be produced at low cost in the above manner.

The probe card of the present invention is composed of the rectangular frame-like anisotropic conductive connector having a three-layered structure formed in one piece as described above and the circuit board for inspection.
Furthermore, the probe card of the present invention is composed of
the rectangular frame-like anisotropic conductive connector having a three-layered structure obtainable by disposing the first anisotropic conductive sheet having a semi-transparent protrusion and a through-hole, the center substrate having a marking and a though-hole and the second anisotropic conductive sheet having a semi-transparent protrusion and a through-hole, in this order, and thereby forming in one piece, and
a circuit board having a marking for inspection.
The positioning of the anisotropic conductive connector having a three-layered structure and the circuit board for inspection is conducted by positioning the semi-transparent protrusion formed on the first or second anisotropic conductive sheet to the marking formed on the circuit board for inspection, and also positioning the other semi-transparent protrusion formed on the first or second anisotropic conductive sheet to the marking formed on the circuit board for inspection.

When the probe card having such a composition is used for electrical inspection of a circuit board for inspection such as wafer or the like, the electrical inspection for a fine and dense circuit board such as wafer or the like can be carried out easily.

The anisotropic conductive sheet of the present invention is composed of:
an anisotropic conductive film having a conductive part formed, which film is disposed inside of an opening of a metal frame,
a semi-transparent protrusion disposed on an opening different from the opening of the metal frame on which the anisotropic conductive film is disposed, and
an elastic film having a non-transparent mark for alignment which film is disposed in the periphery of the semi-transparent protrusion.

Moreover, the anisotropic conductive sheet of the present invention is composed of an anisotropic conductive film having a conductive part, which film is disposed inside of the opening of a metal frame wherein the anisotropic conductive film has a semi-transparent protrusion and a non-transparent mark for alignment disposed in the periphery of the semi-transparent protrusion.

The positioning of such an anisotropic conductive sheet to an object can be carried out easily.

### [Effect of the Invention]

The method for positioning an anisotropic conductive connector according to the present invention can perform the positioning of a flexible anisotropic conductive sheet to an object accurately.
Furthermore, a non-transparent mark for alignment is previously formed in the periphery of a semi-transparent protrusion formed on the anisotropic conductive sheet, whereby the semi-transparent protrusion formed on the anisotropic conductive sheet can be exhibited visually. Therefore, the semi-transparent protrusion can be found easily. As a result, it is possible to conduct the alignment more quickly.

Since a non-transparent mark for alignment is formed in the periphery of a semi-transparent protrusion formed on the anisotropic conductive sheet, the anisotropic conductive sheet is approached to an object at a certain position using the mark for alignment and a marking of the object. Thereafter, fine adjustment is carried out using the semi-transparent protrusion formed on the anisotropic conductive sheet and the marking of the object to perform positioning of the anisotropic conductive sheet and the object. Therefore, the accurate alignment can be carried out effectively.

The positioning of the anisotropic conductive sheet and the object may be carried out in at least two sides. If the positioning is carried out on two sets of two sides which sides are parallel each other, the positioning can be carried out more accurately.

Furthermore, according to the present invention, the three layers of the anisotropic conductive connect can be positioned more accurately.
Moreover, According to the method for positioning the anisotropic conductive connector and the circuit board for inspection, the anisotropic conductive connector and the circuit board for inspection can be positioned more accurately and easily.

According to the anisotropic conductive connector of the present invention, the formation of the semi-transparent protrusion used for positioning can be carried out simultaneously in the process of forming a distributed conductive path by conductive particles, whereby the position precision of the conductive path and the semi-transparent protrusion is high and the production cost is low.

Since the through-hole for positioning formed on the center substrate and the marking are formed simultaneously in the process of forming a circuit region of the center substrate, the position precision of the circuit region, the through-hole for positioning and the marking is high. Therefore, when the anisotropic conductive sheet is positioned using the through-hole for positioning and the marking, the anisotropic conductive sheet having a fine and dense conductive part can be positioned toward electrodes of the center substrate. Furthermore, the position precision to other conductive paths is high, and thereby it is possible to produce a fine and dense anisotropic conductive connector.

On a probe card prepared using the anisotropic conductive connector thus produced and a detecting device, the conductive portion of the anisotropic conductive sheet and the electrodes of the center substrate are positioned accurately. Therefore, inspection for a fine and dense object can be carried out precisely. BEST MODE OF CARRYING OUT THE INVENTION

Preferable embodiments of the method of positioning an anisotropic conductive connector, the method of positioning the anisotropic conductive connector and the circuit board for inspection, the anisotropic conductive connector, and the probe card according to the present invention will be described below in detail with reference to drawings.

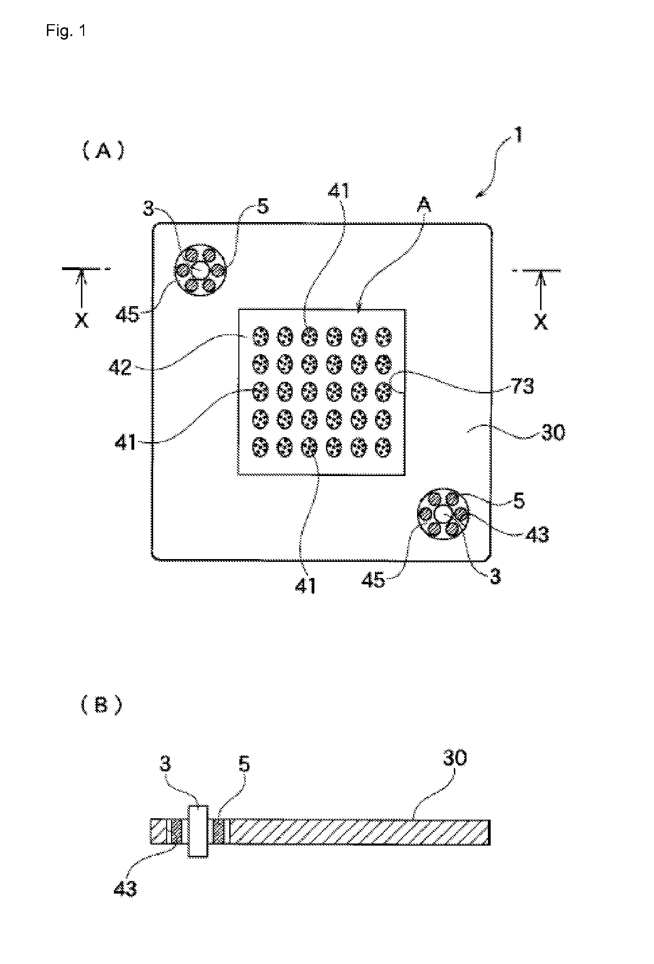

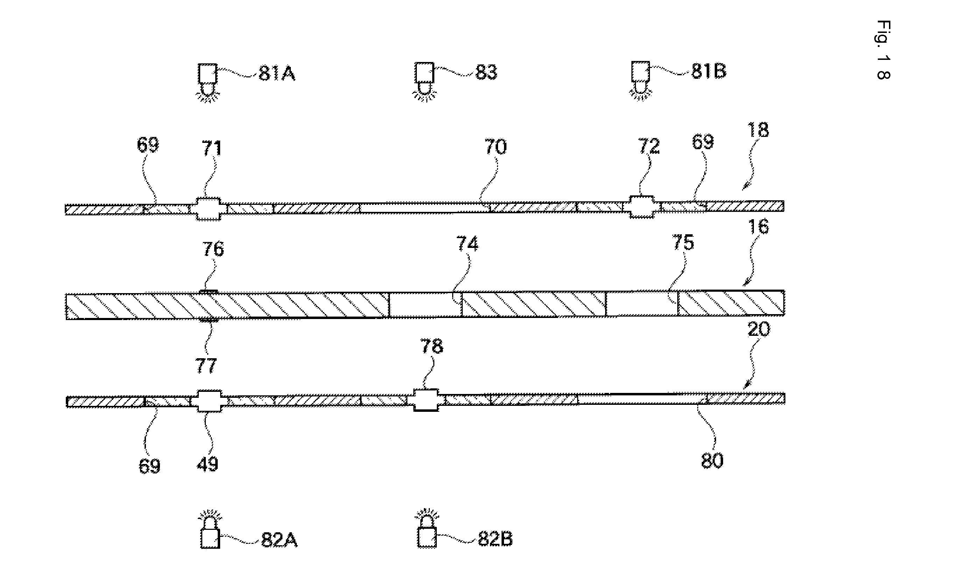

In the present specification, "upper surface" and "lower surface" are expediently used on convenience of explanation. For instance, in Fig. 18, a first anisotropic conductive sheet 18 side is a top or upper surface side regarding a center substrate 16 as the center, and a second anisotropic conductive sheet 20 side is a bottom or a lower surface side regarding a center substrate 16 as the center occasionally. Specifically, a marking 76 of the center substrate 16 is formed on the upper surface of the center substrate 16 and a marking 77 is formed on the lower surface of the center substrate 16. In an anisotropic conductive sheet 1 shown in Fig. 1, the side indicated by X-X is an upper side occasionally. In this case, the side where the line X-X is not indicated is a lower side. Since an anisotropic conductive sheet is an extremely thin film, the ratio of thickness is indicated by a scale different from an actual thickness.

Figs. 1 (A) and (B) show an example of an anisotropic conductive sheet according to the present invention. Fig. 1(A) is a plan view thereof, and Fig. 1(B) is a cross section taken in the X - X line direction of Fig. 1(A).
The anisotropic conductive sheet 1 is provided with an anisotropic conductive film 42 made of an insulating flexible material formed in an opening 73 of a metal frame 30 which frame portion is made of a metal, wherein a conducting portion 41 is formed in a circuit region A which is located in the an almost center of the sheet.

The conducting portion 41 consists of conductive particles contained in an elastic polymer substance. Preferably, conductive particles are oriented in a thickness direction in the elastic polymer matter. By the conductive particles, the conducting portion 41 electrically conducting in a thickness direction is formed. The conducting portion 41 can also be a pressurized conducting path device having properties that a conducting path is formed by the conductive particles when the conducting portion 41 is compressed by pressurization in a thickness direction and thereby the resistance value is decreased.

An insulating member including the conducting portion 41 is formed by hardening a molding material with flow properties in which conductive particles are dispersed in a polymeric substance forming material which becomes an elastic polymer substance by curing.

A forming material of an elastic polymer substance forming the anisotropic conductive film 42 is preferably a material having the same quality as the insulating member including the conducting portion 41. Various materials can be used for the elastic polymer substance for forming the anisotropic conductive film 42 and the insulating member including the conducting portion 41. Examples thereof are conjugated diene rubbers such as polybutadiene rubber, natural rubber, polyisoprene rubber, styrene-butadiene copolymer rubber, acrylonitrile-butadiene copolymer rubber, and hydrogenated products thereof, block copolymer rubbers such as styrene-butadiene-diene block copolymer rubber, styrene-isoprene block copolymer rubber, and hydrogenated products thereof, chloroprene, urethane rubber, polyester rubber, epichlorohydrin rubber, silicone rubber, ethylene-propylene copolymer rubber, and ethylene-propylene-diene copolymer rubber. In the case that a resultant anisotropic conductive sheet is required to have weather resistance, it is preferable to use a material other than conjugated diene rubbers. In particular, it is preferable to use silicone rubber from a viewpoint of molding processability and electrical characteristics.

It is preferred to use conductive magnetic particles as conductive particles from the viewpoint capable of orienting the particles easily. Examples of the conductive magnetic particles may include metal particles having magnetic properties such as iron, cobalt or nickel, particles of an alloy thereof, particles containing the metal, particles obtainable by using these particles as a core particle and plating the core particle surfaces with a metal having good electrical conductivity such as gold, silver, palladium or rhodium, particles obtainable by using non-magnetic metal particles, inorganic substance particles such as glass beads, or polymer particles as a core particle and plating the core particle surfaces with a conductive magnetic material such as nickel or cobalt, particles obtainable by plating the core particle surfaces with both of a conductive magnetic material and a metal having good electrical conductivity. Among them, it is preferred to use the particles obtainable by using nickel particles as a core particle and plating the core particle surfaces with a metal having good electrical conductivity such as gold or silver. The means for covering the core particle surfaces with a conductive metal is not particularly restricted. For example, the covering can be carried out by chemical plating, electroless plating or sputtering.

In the anisotropic conductive sheet 1, a semi-transparent protrusion 3 is formed on each of two sides of the four sides surrounding a circuit region A. The two sides on which the semi-transparent protrusion 3 is formed are the upper side on which the X-X line is drawn and the lower side on the opposite side. A distance from the conducting portion 41 can be determined arbitrarily.

The semi-transparent protrusion 3 can be formed on the anisotropic conductive film 42 having the conducting portion 41. Moreover, an opening 43 is formed in the metal frame 30 separately from the opening 73 in which the anisotropic conductive film 42 is disposed, an elastic film 45 made of an insulating flexible material is formed in the opening 43, and the semi-transparent protrusion 3 can be formed on the elastic film 45. The anisotropic conductive film 42 and the elastic film 45 can be formed in one sheet, or separately in two sheets. Even if the anisotropic conductive film 42 and the elastic film 45 are formed in one sheet or two sheets, they are formed in the same mold through the same mold frame.

In the case of forming the elastic film 45 separately from the anisotropic conductive film 42, a polymeric substance forming material, which forms the elastic film 45 and becomes an elastic polymer substance by curing, is preferably the same as a material forming the anisotropic conductive film 42.

The semi-transparent protrusion 3 can be formed simultaneously in a process of forming the circuit region A in a mold as described later.
As shown in Fig. 1(B), the semi-transparent protrusion 3 is in an almost cylindrical shape protruding to the surface and back faces.
A non-transparent alignment mark 5 is preferably formed on the annular portion surrounding the cylindrical protrusion 3.

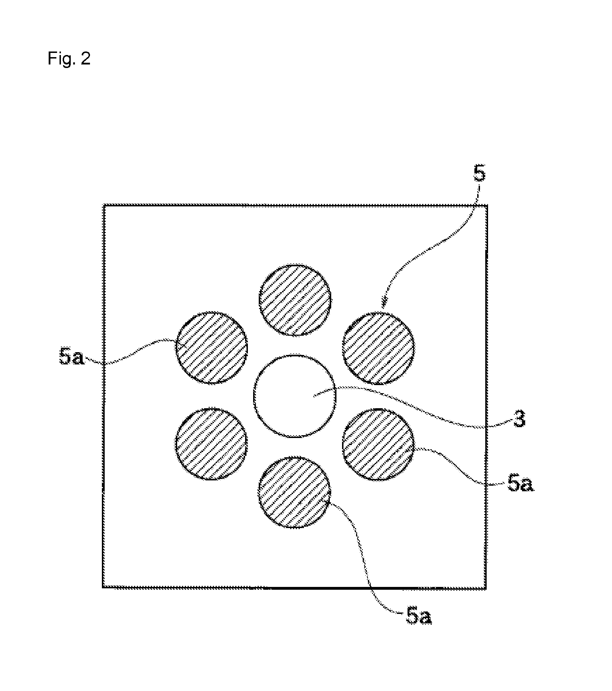

The non-transparent alignment mark 5 enlargedly shown in Fig. 2 can be formed by embedding a colored resin plate in an elastic polymer substance, by forming a concave portion on the surfaces of the anisotropic conductive film 42 and the elastic film 45 and applying a coloring agent in the concave portion, by forming minute concave and convex on the surfaces of the anisotropic conductive film 42 and the elastic film 45, or by arranging a plurality of conductive particles 5a in an elastic polymer substance in a thickness direction locally.

Since the semi-transparent cylindrical protrusion 3 is surrounded by the non-transparent alignment marks 5 as described above, the position of the semi-transparent protrusion 3 can be visually stood up from the outside.
Meanwhile, an object to which the anisotropic conductive sheet 1 is positioned is the center substrate having the almost same shape, which is laminated on the anisotropic conductive sheet 1.

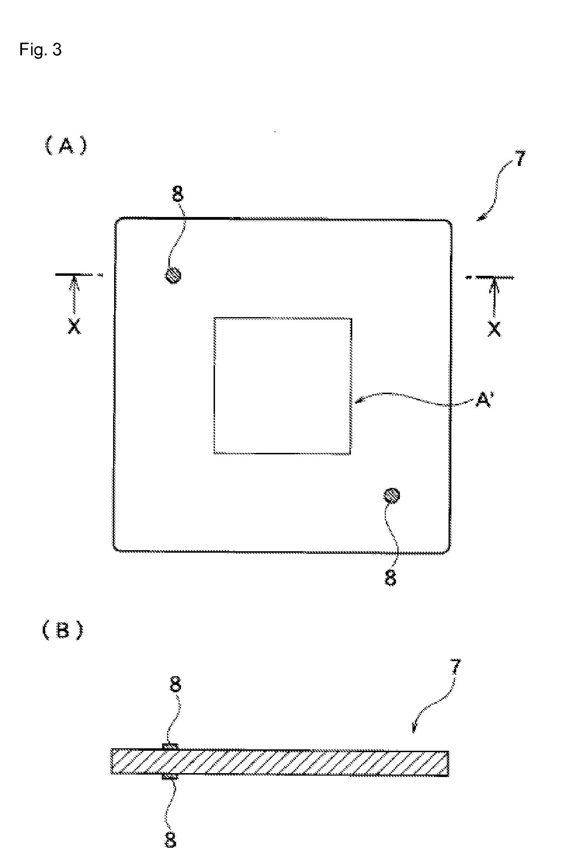

In the case that the object is the center substrate, a circuit region A' is formed on the center substrate as shown in Fig. 3(A) similarly to the circuit region A in the anisotropic conductive sheet 1. A marking 8 is previously formed on the predetermined position of the object 7 in order to align with the anisotropic conductive sheet 1 shown in Fig. 1. The position on which the marking 8 is formed corresponds to the position of the semi-transparent protrusion 3 present on the upper and lower surfaces of the anisotropic conductive sheet 1 shown in Fig. 1. By aligning them with precision, the conducting portion 41 of the anisotropic conductive sheet 1 and the conducting portion of the object 7 is aligned accurately.

In the case that the object 7 is the center substrate, the anisotropic conductive sheet 1 is laminated on each of the upper and lower surfaces of the center substrate, to form a three-layered structure interposing the center substrate. Consequently, as shown in the cross section of Fig. 3(B) taken along the X-X line of Fig. 3(A), the markings 8 are formed on the both sides of the object 7 in the present embodiment.

The accurate positioning of the anisotropic conductive sheet 1 shown in Fig. 1 to the object 7 shown in Fig. 3 may be carried out by the procedure as shown in Fig. 4.
Specifically, the anisotropic conductive sheet 1 on which the anisotropic conductive film 42 is fixed by the metal frame 30 on the plane is positioned to the object 7. In this case, the anisotropic conductive sheet 1 is moved relatively to the object 7 so as to bring the semi-transparent protrusion 3 to approach the marking 8. Since the semi-transparent protrusion 3 is visually unremarkable, the alignment is carried out by using, as a mark, the alignment mark 5 located around the protrusion 3. As described above, the anisotropic conductive sheet 1 is moved widely to bring it to roughly approach the marking 8 utilizing the non-transparent alignment mark 5.

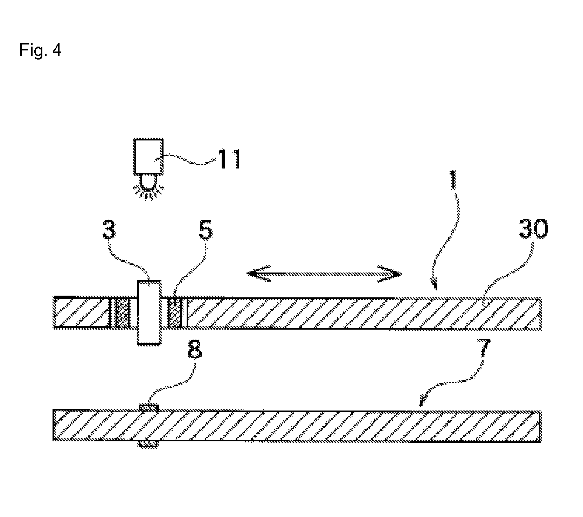

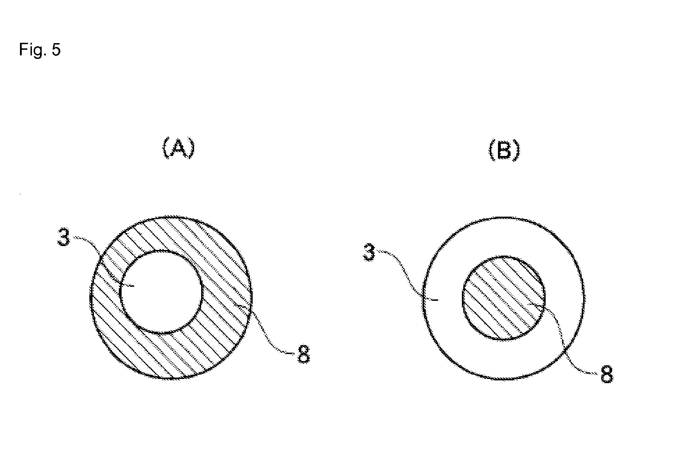

When a detection means 11 detects that the alignment mark 5 is almost aligned to the marking 8 as shown in Fig. 4, the anisotropic conductive sheet 1 is further moved slowly in a horizontal direction to finely adjust the position while identifying by the detection means 11. The semi-transparent protrusion 3 is then projected, and the marking 8 of the object 7 located on the rear face of the semi-transparent protrusion 3 is identified by the detection means 11. At this time, as shown in Fig. 5(A), it is preferable to carry out the final adjustment in such a manner that the outline of the semi-transparent protrusion 3 is aligned to the center of the marking 8.

As shown in Fig. 5(A), the diameter of the marking 8 may be larger than that of the protrusion 3, or the diameter of the marking 8 may also be smaller than that of the protrusion 3 as shown in Fig. 5 (B) . The relation in size between the marking 8 and the semi-transparent protrusion 3 is not restricted. As described above, the alignment of the anisotropic conductive sheet 1 and the object 7 is carried out.

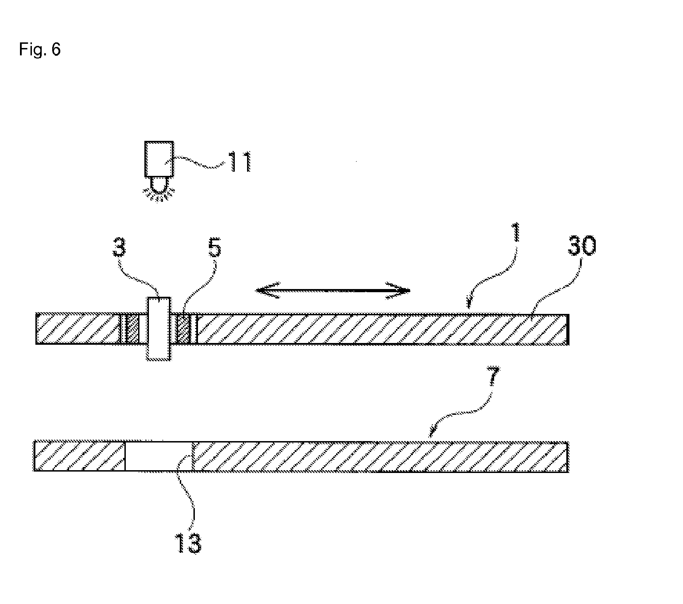

Such an alignment can be carried out on at least two sides of the upper side and the lower side shown in Fig. 1 and at one point for one side.
In the above embodiment, the marking 8 is previously formed on the object 7 that is laminated on the anisotropic conductive sheet
1. As shown in Fig. 6, a through-hole 13 can also be formed at the predetermined position of the object 7 instead of the marking 8. In this case, the semi-transparent protrusion 3 of the anisotropic conductive sheet 1 is aligned to the through hole 13, and this state is detected by the detection means 11.

In this case, the non-transparent alignment mark 5 is almost identified by the detection means 11 at first, and then the semi-transparent protrusion 3 is projected, and thereby the through-hole 13 of the object 7 located on the rear face of the protrusion 3 can be identified.

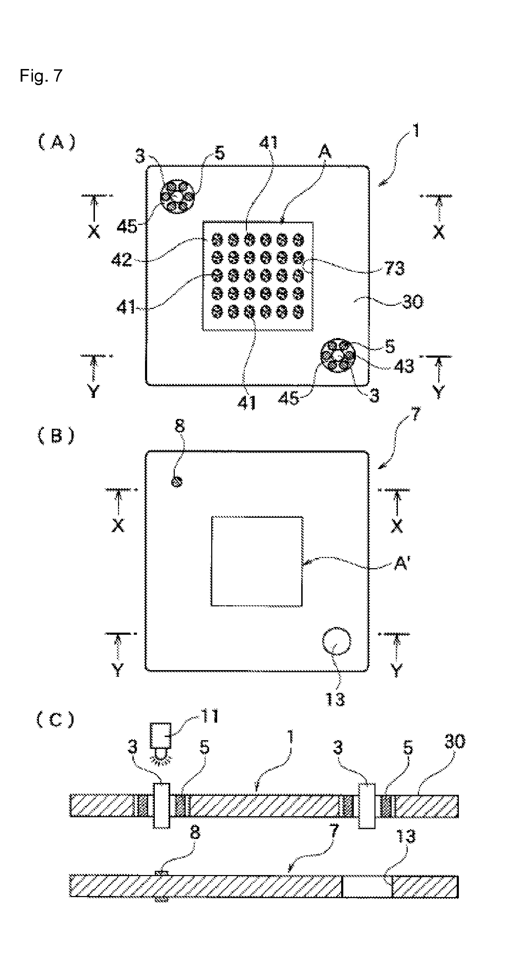

Fig. 7 shows another embodiment.
In this embodiment as shown in Fig. 7(A), the semi-transparent protrusion 3 is formed on each of the upper side and the lower side of the anisotropic conductive sheet 1. Specifically, the structure of the anisotropic conductive sheet 1 is the same as that shown in Fig. 1. As shown in Fig. 7(B), on the object 7 that is laminated on the anisotropic conductive sheet 1, the marking 8 and the through-hole 13 are formed on the upper side and the lower side, respectively. That is, the marking 8 is formed on one side and the through-hole 13 is formed on the other side on the object 7.

The positioning of the anisotropic conductive sheet 1 shown in Fig. 7(A) on the object 7 shown in Fig. 7(B) is carried out in the procedure shown in Fig. 7(C).
Specifically, by superimposing Figs. 7(A) and 7(B), the semi-transparent protrusion 3 is aligned to the marking 8 on the X-X line, and the semi-transparent protrusion 3 is aligned to the through-hole 13 on the Y-Y line. As described above, the protrusion 3 is aligned to the marking 8 on the upper side indicated by the X-X line, and the protrusion 3 is aligned to the through-hole 13 on the lower side indicated by the Y-Y line. In this case, the positioning is carried out on at least two sides similarly to the above embodiment.

Even in the positioning method as shown in Figs. 7(A), 7(B), and 7(C), the anisotropic conductive sheet 1 can be positioned to the object 7 accurately.
As described above, in the present invention, the positioning of the conductive sheet 1 and the object 7 may be carried out at two sides that are parallel to each other or adjacent to each other.

In the present invention, the positioning with higher precision is preferably carried out at four sides including the right and left sides in addition to the upper side and the lower side.

Moreover, the positioning can be carried out at two or more points on one side (besides the positioning at one point per one side) . When the positioning is carried out at two points on one side, the positioning is carried out in two sides of the upper and lower sides, at four points in total, and the positioning is carried out in the upper, lower, right and left sides, namely, at eight points in total. As described above, when the positioning is carried out at two points per side and on four sides, the positioning can be carried out more accurately.

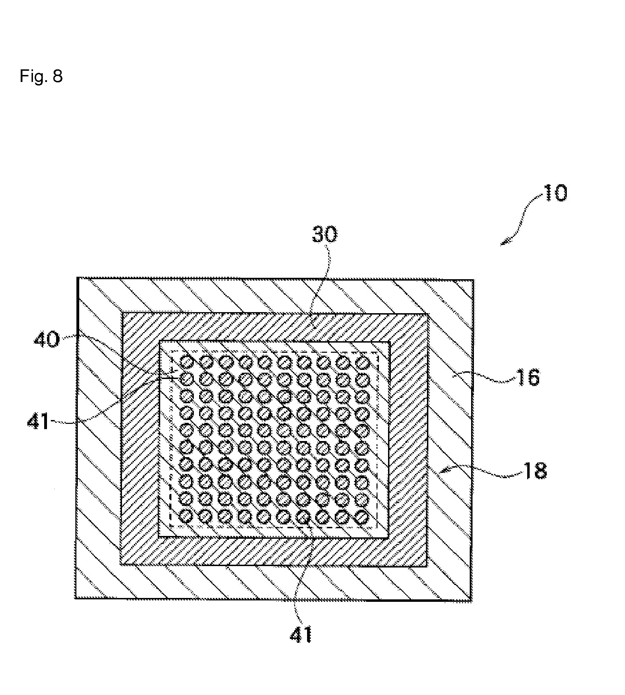

Fig. 8 is a schematic plan view showing an anisotropic conductive connector 10 according to the present invention.
The anisotropic conductive connector 10 is a three-layered laminate having a square shape in a planar view. The anisotropic conductive connector 10 is composed of an electrical circuit region in which a suitable conducting portion 41 is formed in a thickness direction and a frame-like portion which supports the circuit region.

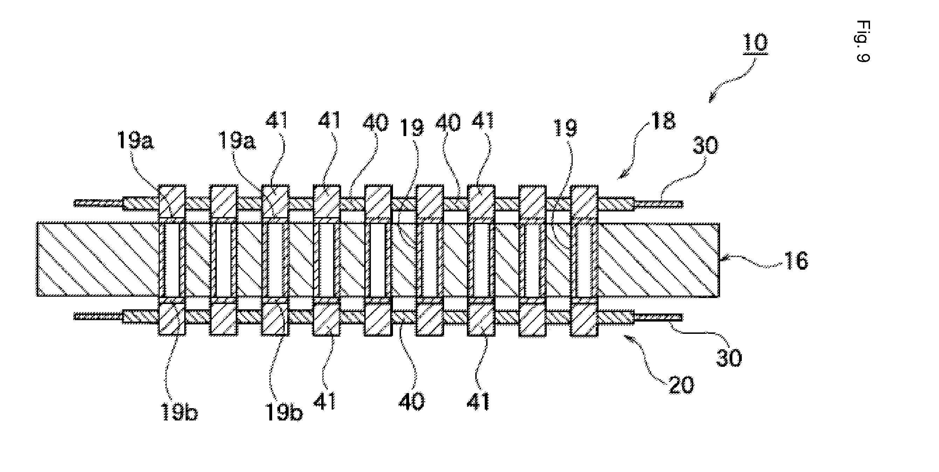

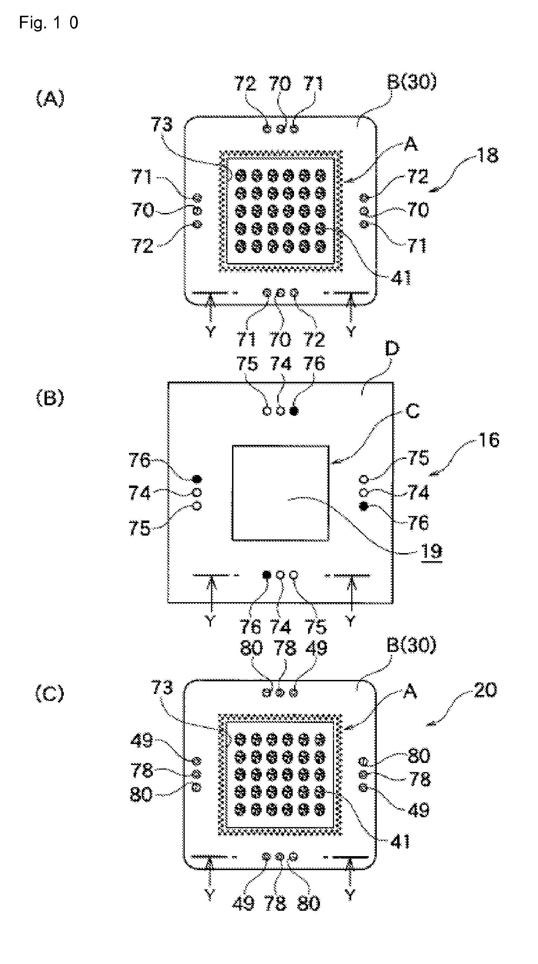

As shown in Fig. 9 and Figs. 10(A), 10(B), and 10(C), the anisotropic conductive connector 10 is composed of a center substrate 16 having suitable rigidity, a first anisotropic conductive sheet 18 laminated on one face of the center substrate 16, and a second anisotropic conductive sheet 20 laminated on the other face of the center substrate 16.

As shown in Fig. 9 and Fig. 10(B), the center substrate 16 is formed in a thin square plate shape. In the present embodiment, in the center substrate 16, a circuit region C and a frame-like portion D are formed from one piece of silicon. As shown in Fig. 9, in the center substrate 16 (silicon substrate 16), a plurality of conductive paths 19 vertically penetrating to the upper and lower faces are formed in the circuit region C. Each of the conductive paths 19 is formed one to one corresponding to a plurality of electrode pads on a wafer for inspection. An upper connection terminal 19a is formed at the upper end of the conductive path 19, and a lower connection terminal 19b is formed at the lower end of the conductive path 19.
The processing of the center substrate 16 made of silicon is carried out by etching processing using the photolithographic technique. As the center substrate 16, a ceramic substrate or a substrate made of a resin material can be used in place of the silicon substrate.

The first anisotropic conductive sheet 18 and the second anisotropic conductive sheet 20 are provided with a metal frame 30 which frame portion B is made of a metal. The conducting portions 41 formed in the circuit region A of the first anisotropic conductive sheet 18 and the second anisotropic conductive sheet 20 are formed projecting to the both sides.

The metal frames 30 of the first anisotropic conductive sheet 18 and the second anisotropic conductive sheet 20 may be changed to a support made of a resin. Moreover, the conducting portions 41 formed in the circuit region A of the first anisotropic conductive sheet 18 and the second anisotropic conductive sheet 20 can be not formed projecting to the both sides, and one face or the both faces of the conducting portion 41 can be on the same level as an insulating portion 40 around the conducting portion 41.

As shown in Fig. 9 and Fig. 10(A), in the first anisotropic conductive sheet 18 disposed on one face of the center substrate 16, the conducting portion 41 made of conductive particles electrically conductive in a thickness direction is formed at the position corresponding to the conductive path 19 of the center substrate 16.

Each of the conducting portions 41 is mutually insulated by the insulating portion 40.
The conducting portion 41 is composed of conductive particles contained in an elastic polymer substance. Preferably, the conductive particles are oriented in a thickness direction in the elastic polymer substance. By the conductive particles, the conducting portion 41 electrically conducting in a thickness direction is formed. The conducting portion 41 can also be a pressurized conducting path device such that when the conducting portion 41 is compressed by pressurizing in a thickness direction, a resistance value is decreased and thereby a conducting path is formed by the conductive particles.

An insulating member including the conducting portion 41 is formed by hardening a molding material having fluid properties obtainable by dispersing conductive particles in a polymeric substance forming material that becomes an elastic polymer substance by curing.
The elastic polymer substance consisting the insulating portion 40 and an insulating member containing the conducting portion 41 have the same qualities.

The conducting portion 41 is formed in the circuit region A of the first anisotropic conductive sheet 18.
Examples of a metal constituting the metal frame 30 of the first anisotropic conductive sheet 18 may include metals such as iron, nickel, titanium and aluminum, alloys obtainable by combining at least two of the metals and alloy steels.

The material constituting the metal frame 30 has a coefficient of linear thermal expansion of lower than 3 X 10⁻⁵ /K, and is more preferably 1 X 10⁻⁶ to 8 X 10⁻⁶ /K.
Specific examples of the material may include invar alloys such as invar, elinvar alloys such as elinvar, super invar, covar or 42-alloy and alloy steels.

The second anisotropic conductive sheet 20 is formed almost in the almost same manner as in the first anisotropic conductive sheet 18.
The first anisotropic conductive sheet 18 and the second anisotropic conductive sheet 20 can be formed by, for example, the following method.

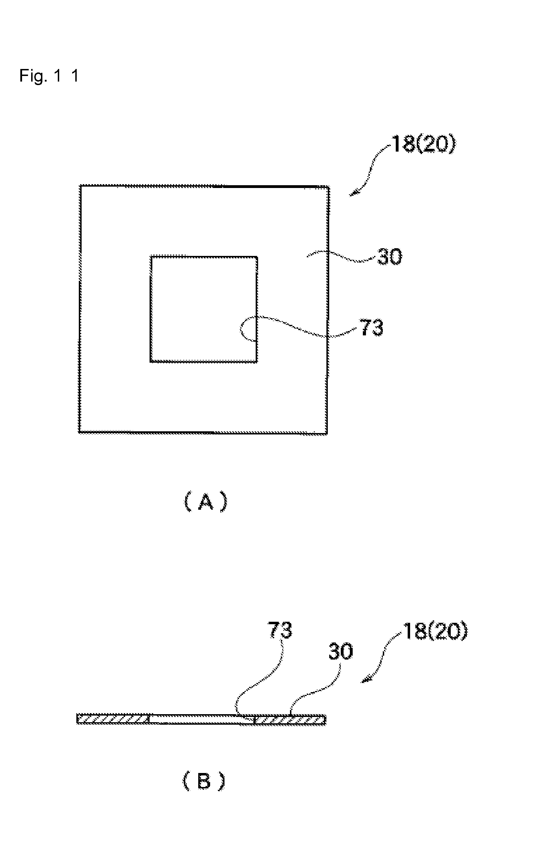

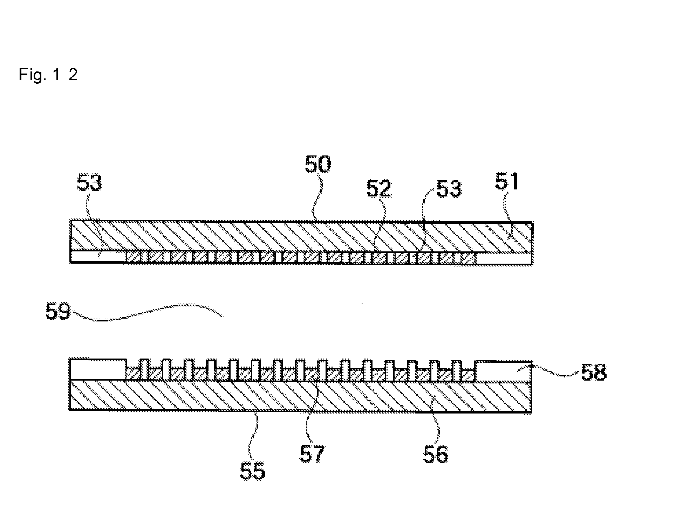

As shown in Fig. 11(A) and Fig. 11(B), in the preparation of the first anisotropic conductive sheet 18 and the second anisotropic conductive sheet 20, the metal frame 30 in which a rectangular opening 73 is formed at the center is previously prepared. The circuit region A is then formed in the opening 73 formed on the metal frame 30. In the present embodiment, the metal frame 30 is disposed in the mold as shown in Fig. 12.

The mold is composed of an upper mold 50 and a lower mold 55, and a molding space 59 is formed between the upper mold and the lower mold.
In the upper mold 50, a ferromagnetic layer 52 is formed on the surface of a ferromagnetic substrate 51 according to the pattern of the conducting portion 41 in the objective anisotropic conductive sheets 18 and 20. A non-magnetic layer 53 having a thickness substantially same as that of the ferromagnetic layer 52 is formed on the portion other than the ferromagnetic layer 52.

In the lower mold 55, a ferromagnetic layer 57 is formed on the surface of a ferromagnetic substrate 56 according to the pattern of the conducting portion 41 in the objective anisotropic conductive sheet 18 and 20. A non-magnetic layer 58 having a thickness larger than that of the ferromagnetic layer 57 is formed on the position other than the ferromagnetic layer 57.

Usable examples of a material forming the ferromagnetic substrates 51 and 56 in the upper mold 50 and the lower mold 55, may include ferromagnetic metals such as iron, iron-nickel alloy, iron-cobalt alloy, nickel, and cobalt. The ferromagnetic substrates 51 and 56 preferably have a thickness of 0.1 to 50 mm and a flat and smooth surface, prepared by degreasing processing chemically or polishing mechanically.

Usable examples of the material forming the ferromagnetic layers 52 and 57 in the upper mold 50 and the lower mold 55, may include ferromagnetic metals such as iron, iron-nickel alloy, iron-cobalt alloy, nickel, and cobalt. The ferromagnetic layers 52 and 57 preferably have a thickness of at least 10 µm. When the thickness is less than 10 µm, it is difficult to apply a magnetic field having a sufficient intensity distribution to a molding material layer formed in the mold. As a result, it is difficult to gather conductive particles at a high density in the portion to be the conducting portion 41 in the molding material layer, and thereby the satisfactory anisotropic conductive sheets 18 and 20 are not obtained occasionally.

Usable examples of the material forming the non-magnetic layers 53 and 58 in the upper mold 50 and the lower mold 55 may include non-magnetic metals such as copper and polymer substances having heat resistance. However, it is preferable to use a polymer substance cured by radiation from a viewpoint that the non-magnetic layers 53 and 58 can be easily formed by a photolithography technique. Usable examples of the material thereof may include photo-resists such as acrylic dry film resist, epoxy liquid resist, and polyimide liquid resist.

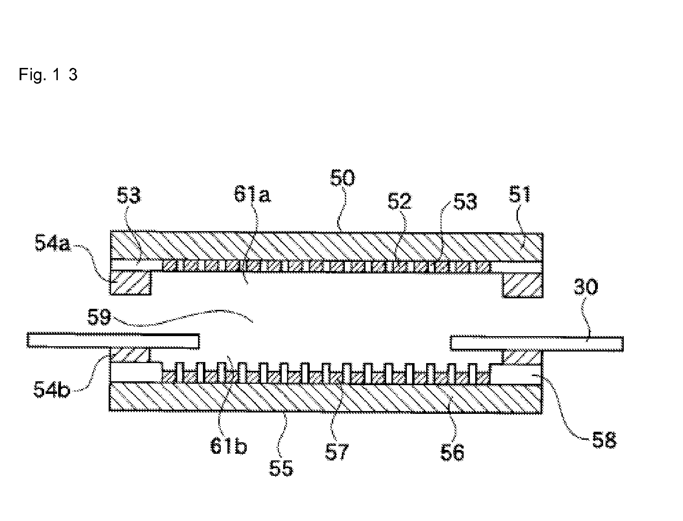

Using the above mold, the first anisotropic conductive sheet 18 and the second anisotropic conductive sheet 20 are produced in the following manner.
At first, as shown in Fig. 13, frame-like spacers 54a and 54b and the metal frame 30 for a support having the opening 73 as shown in Figs. 11(A) and 11 (B) are prepared, and the metal frame 30 is then disposed and fixed on the predetermined position of the lower mold 55 through the spacer 54b, and the spacer 54a is disposed in the upper mold 50.

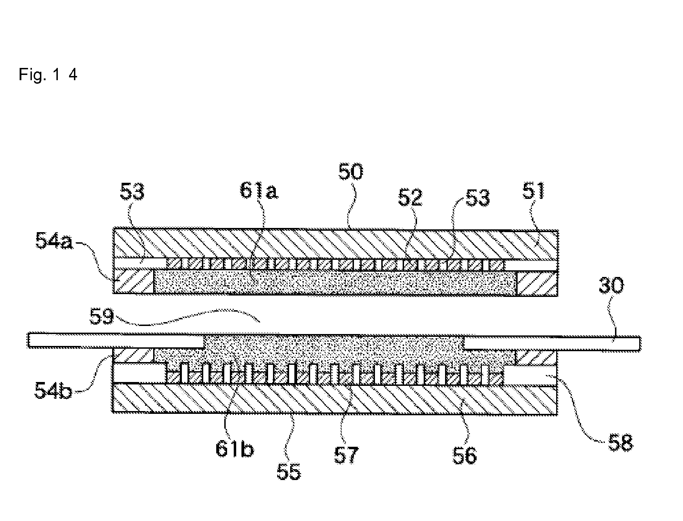

On the other hand, a pasty molding material is prepared by dispersing conductive particles indicating magnetic properties in a curing polymeric substance forming material such as silicone rubber.
Subsequently, as shown in Fig. 14, a first molding material layer 61a is formed by filling a space formed by a spacer 54a on the molding face of the upper mold 50 with a molding material, while a second molding material layer 61b is formed by filling a space formed by the lower mold 55, a spacer 54b and the metal frame 30 with a molding material.

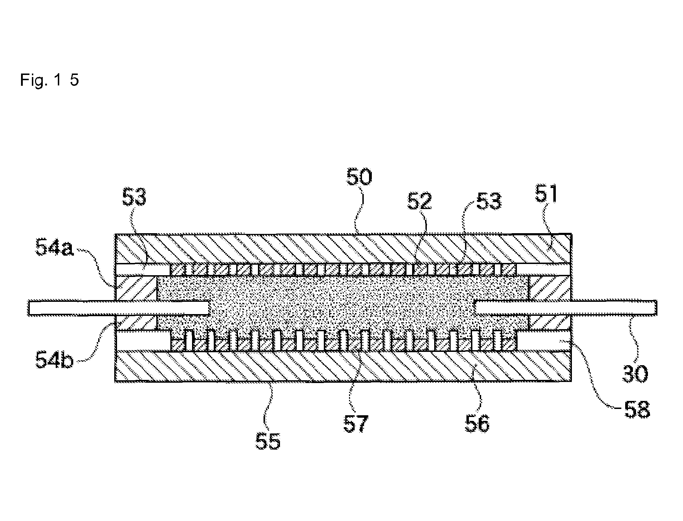

As shown in Fig. 15, the first molding material layer 61a is laminated on the second molding material layer 61b by positioning and disposing the upper mold 50 on the metal frame 30.
A parallel magnetic field having an intensity distribution is applied to the first molding material layer 61a and the second molding material layer 61b in a thickness direction by activating an electromagnet (not shown) disposed on the upper face of the ferromagnetic substrate 51 of the upper mold 50 and the lower face of the ferromagnetic substrate 56 of the lower mold 55. That is, a parallel magnetic field having a large intensity between the ferromagnetic layer 52 of the upper mold 50 and the corresponding ferromagnetic layer 57 of the lower mold 55 is applied to the first molding material layer 61a and the second molding material layer 61b.
As a result, in the first molding material layer 61a and the second molding material layer 61b, conductive particles dispersed in each molding material layer gather in the portion to be the conducting path 41 located between the ferromagnetic layer 52 of the upper mold 50 and the corresponding ferromagnetic layer 57 of the lower mold 55, and the conductive particles are oriented in a thickness direction of each molding material layer.

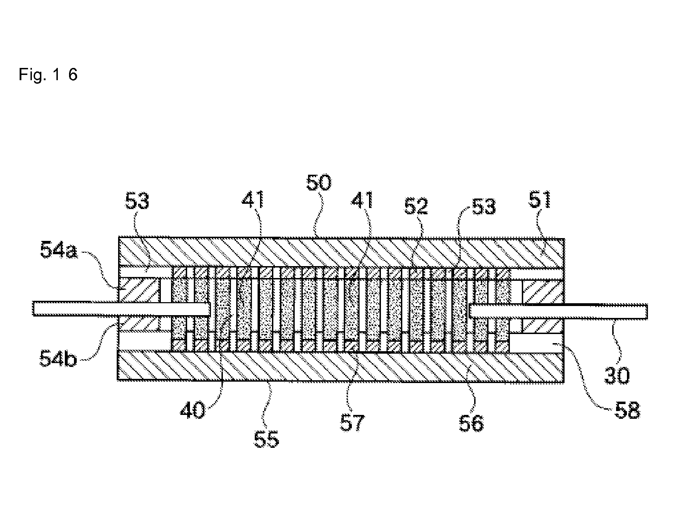

As shown in Fig. 16, by curing each molding material layer in this state, the first anisotropic conductive sheet 18 or the second anisotropic conductive sheet 20 is formed so as to have the conducting portion 41 densely filled with conductive particles oriented in a thickness direction in an elastic polymer substance, and the insulating portion 40 formed surrounding the conducting portion 41 and made of an insulating elastic polymer substance in which conductive particles do not exist at all or mostly.

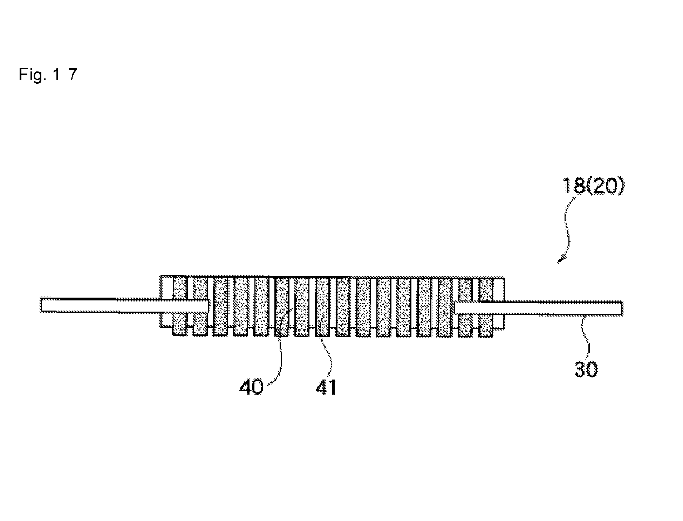

After molding, the first anisotropic conductive sheet 18 or the second anisotropic conductive sheet 20 is taken out from the upper mold 50 or the lower mold 55, thereby obtaining the first anisotropic conductive sheet 18 or the second anisotropic conductive sheet 20 shown in Fig. 17. The conducting portion 41 may be projected upward and downward.

When an anisotropic conductive sheet having a three-layered structure is formed, it is necessary to position three layers each other accurately. Therefore, the first anisotropic conductive sheet 18, the center substrate 16, and the second anisotropic conductive sheet 20 are provided with the following structure for positioning.

The structure for positioning a laminate having a three-layered structure according to the present invention will be described below with reference to Fig. 10.
The circuit region A in an almost center position of the first anisotropic conductive sheet 18 and the second anisotropic conductive sheet 20 is supported by the four sides of the metal frame-like portion B. Viewing the four sides in the states of Figs. 10(a), 10(B) and 10(C), the upper, lower, left and right sides are represented by an upper side portion, a lower side portion, a left side portion and a right side portion. Although the structure of the lower side portion will be described in the following, other side portions are also formed similarly. Fig. 18 is a cross section taken on the Y-Y line in Figs. 10(a), 10(B), and 10(C).

The structure for positioning described below is formed simultaneously in the process of forming the circuit region A in the first anisotropic conductive sheet 18, the center substrate 16, and the second anisotropic conductive sheet 20. Specifically, in the anisotropic conductive sheets 18 and 20, the formation of the structure for positioning is carried out in the process as shown in Figs. 12 to 17. In the center substrate 16, through-holes 74 and 75 for positioning are formed simultaneously in a process of forming a conductive path 19 in the circuit region A. A marking 76 to be formed in the center substrate 16 is formed simultaneously in a process of forming the connection terminals 19a and 19b in the circuit region A.

As shown in Fig. 18 and Fig. 10(A), a through hole 70 is formed at the center of the Y-Y line in the first anisotropic conductive sheet 18, and a closed hole 69 that is closed later is formed on the both sides thereof.

The closed hole 69 is filled with a pasty silicone rubber or the like, and thereby a first semi-transparent protrusion 71 and a second semi-transparent protrusion 72 are formed in the molds 50 and 55. The semi-transparent protrusions 71 and 72 are projected to the both faces and have an almost cylindrical shape. It is preferred that a non-transparent alignment mark be formed on the annular portion surrounding the cylindrical protrusions 71 and 72. As described above, the alignment mark is formed by dispersing and mixing conductive particles.

By forming the non-transparent alignment mark, the cylindrical protrusions 71 and 72 can be easily identified. After the identification of the cylindrical protrusions 71 and 72, the semi-transparent protrusion can be identified, and thereby precise positioning can be carried out.

In the first anisotropic conductive sheet 18 according to the present embodiment, the protrusion 71, the through hole 70, and the protrusion 72 are formed in the order of from left to right in the Y-Y cross section. Similarly, on other three side portions of the first anisotropic conductive sheet 18, the protrusion 71, the through hole 70, and the protrusion 72 are formed in this order. Specifically, in the first anisotropic conductive sheet 18, at least two semi-transparent protrusions 71 and 72, and at least one through-hole 70 are formed separately from each other at a predetermined space on one side.

On the center substrate 16, a through hole 74 is formed at the center in the Y-Y cross section, and a through-hole 75 is formed on the right side thereof. That is, two through-holes 74 and 75 are formed on one side in the center substrate 16. Moreover, a marking 76, which can be identified from the outside, is formed on the left side of the center through-hole 74. The marking 76 is preferably colored in an almost circular shape and formed slightly larger than the outline of the protrusion 71. Moreover, a marking 77 is formed on the rear face of the center substrate 16 corresponding to the marking 76 on the upper face side. Since the marking 76 can be viewed from the outside, the position of the through holes 74 and 75 can be confirmed by using the marking 76.

Accordingly, in the embodiment, on the center substrate 16, the marking 76, the through-hole 74 and the through-hole 75 are formed individually in the order of from left to right in the Y-Y line.
In the second anisotropic conductive sheet 20, a semi-transparent protrusion 78 is formed in the center of the Y-Y line, a semi-transparent protrusion 49 is formed in the left of the protrusion 78 and a through-hole 80 is formed in the right of the center protrusion 78 respectively. The other three sides are formed similarly.

Therefore, in the second anisotropic conductive sheet 20, the protrusion 49, the protrusion 78 and the through-hole 80 are individually formed in the Y-Y line in the order of from left to right.
Each of the three layers is positioned in the following manner.

At first, of the three layers, the first anisotropic conductive sheet 18 is almost superimposed on the center substrate 16. The first protrusion 71 is projected and the marking 76 of the center substrate 16 present in the rear face of the protrusion 71 is identified using a first detecting means 81A disposed in the side of the first anisotropic conductive sheet 18.

In this condition, it is difficult to view the semi-transparent protrusion 71 in the first anisotropic conductive sheet 18 from the outside. However, if a non-transparent alignment mark is previously formed around the protrusion, the semi-transparent protrusion 71 can be easily found using the alignment mark. Since the marking 76 of the center substrate 16 is made of the same material as the upper and lower connecting terminals, it has high brightness and high visibility.

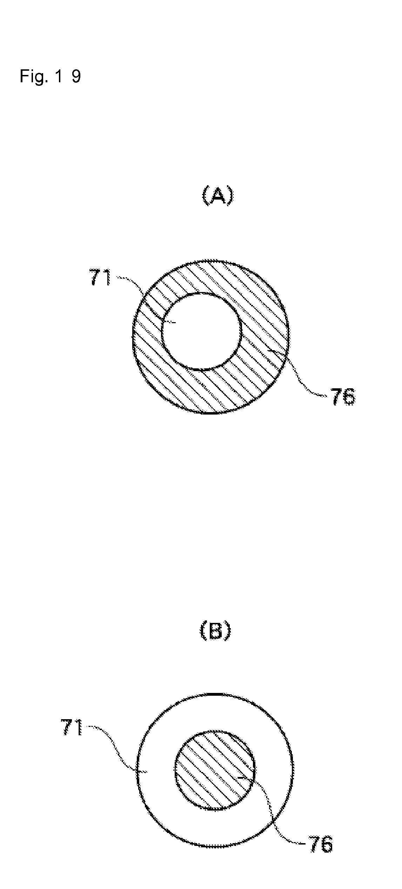

Successively, the through-hole 75 of the center substrate 16 is identified through the second semi-transparent protrusion 72 by a second detecting means 81B disposed on the side of the first anisotropic conductive sheet 18. In this case, the rough alignment is also preferably carried out using the non-transparent alignment mark formed around the second semi-transparent protrusion 72. In carrying out the positioning, it is preferred to carry out fine adjustment for aligning the outline of the first protrusion 71 to the center of the marking 76 and also for aligning the second protrusion 72 to the center of the through-hole 75 as shown in Fig. 19 (A). For example, as shown in Fig. 19 (B), the diameter of the marking 76 is made to be smaller than the diameter of the protrusion 71 and the marking 76 can be aligned to the center of the protrusion 71.

If the above positioning is not carried out completely, the first anisotropic conductive sheet is moved relatively. In this manner, the positioning of the first anisotropic conductive sheet 18 and the center substrate 16 is accomplished. After the completion of the positioning of the first anisotropic conductive sheet 18 and the center substrate 16, the second anisotropic conductive sheet 20 is disposed in the lower of the laminate.

In the same manner as above, the first protrusion 49 of the second anisotropic conductive sheet 20 is projected and the marking 77 of the center substrate 16 present in the rear face of the protrusion 49 is identified using a third detecting means 82A disposed in the side of the second anisotropic conductive sheet 20. The second protrusion 78 of the second anisotropic conductive sheet 20 is, further, projected and the through-hole 74 of the center substrate 16 present in the rear face of the protrusion 78 is identified using a fourth detecting means 82B disposed in the side of the second anisotropic conductive sheet 20. In this procedure, fine adjustment is preferably carried out in the same manner as in Fig. 19 (A) and (B).

Furthermore, by means of a fifth detecting means 83 disposed in the side of the first anisotropic conductive sheet 18 in addition to the first detecting means 81, the second protrusion 78 of the second anisotropic conductive sheet 20 is detected through a through-hole 70 and the through-hole 74 and thereby confirmation of the positioning may be carried out. The second detecting means 81B or the first detecting means 81A may be used in such a way that it is moved in a parallel direction as the fifth detecting means 83.

In this manner, the first anisotropic conductive sheet 18, the center substrate 16 and the second anisotropic conductive sheet 20 are positioned accurately. After the completion of positioning of the two or three layers, for example, the three layers are fixed mutually by means of a silicon adhesive to prepare an anisotropic conductive connector having a three layered structure 10.

In positioning the three layers of the first anisotropic conductive sheet 18, the center substrate 16 and the second anisotropic conductive sheet 20, for example, when the two layers of the first anisotropic conductive sheet 18 and the center substrate 16 is carried out, it is preferred to carry out the positioning in four sides of up, down, left and right sides at the total eight points. As described above, the positioning of the first anisotropic conductive sheet 18 and the center substrate 16 is carried out on at least two points per one side, namely at total eight points in the four sides, to perform highly accurate positioning.

The positioning of the second anisotropic conductive sheet 20 and the center substrate 16 is preferably carried out in the same manner as above, namely, at two points per one side, in four sides. Performing such positioning, a highly dense obj ect for inspection can be inspected with high accuracy.

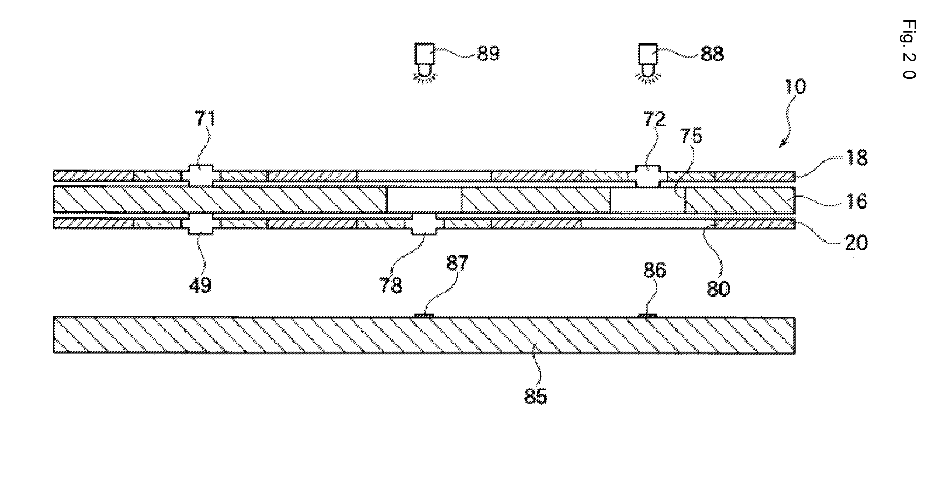

In the case that the anisotropic conductive connector having a three-layered structure 10 is used as a connector for actual inspection, it is necessary to connect an inspective circuit board 85 to the side of the second anisotropic conductive sheet 20 in the laminated anisotropic conductive connector 10 as shown in Fig. 20. In this case, it is necessary to position the inspective circuit board 85 accurately in the same manner as the mutual positioning of the anisotropic conductive connector 10.

On this account, in the inspective circuit board 85, it is necessary to previously form two markings 86 and 87 capable of being identified from the outside per one side. Therefore, at least two markings 86 and 87 are previously provided per one side on the inspective circuit board 85 and thereby eight markings in total are provided on the four sides. As a result, the conductive portion of the inspective circuit board 85 can be positioned on the electrodes of the anisotropic conductive connector 10 accurately.

AS shown in Fig. 20, the inspective circuit board 85 is disposed on the lower side of the laminated anisotropic conductive connector 10, and while it is moving relatively, the marking 86 is identified through the second protrusion 72, the through-hole 75 and the through-hole 80 by a sixth detecting means 88 and also the second protrusion 78 of the second anisotropic conductive sheet 20 and the marking 87 of the inspective circuit board 85 are identified by a seventh detecting means 89. In this case, it is also preferred to carry out fine adjustment as shown in Fig. 19 (A) and (B).

The first detecting means 81A, the second detecting means 81B or the fifth detecting means 83 can be used as the sixth detecting means 88 and the seventh detecting means 89. That is to say, in the present embodiment, it is effective to use at least one detecting means, which is disposed on the side of the first anisotropic conductive sheet 18. However, from the practical point of view, two detecting means are actually disposed and used in such a way that they are moved in a parallel direction.

As described above, the positioning of the anisotropic conductive connector 10 thus laminated and the inspective circuit substrate 85 is completed. Furthermore, when they are bonded with a silicon adhesive, the anisotropic conductive connector 10 and the inspective circuit substrate 85 are fixed in one piece at a proper position. By the fixing thereof, the probe card 90 of the present invention can be formed.

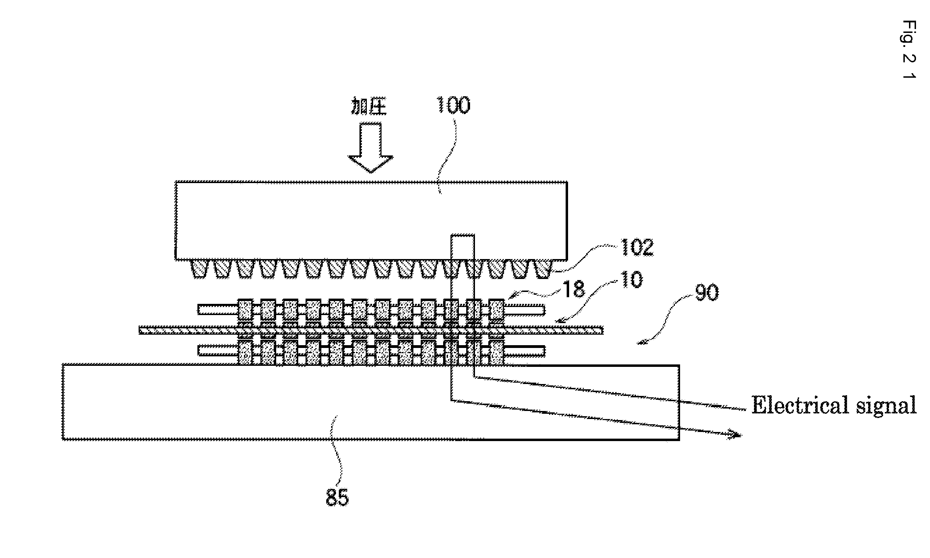

As shown in Fig. 21, electrical circuits of a circuit substrate 100 such as a wafer or the like can be properly detected by carrying out the positioning and fixing in the above manner.
That is to say, the three-layered anisotropic conductive connector 10 and the inspective circuit board 85 are positioned properly, and the inspective circuit board 100 is disposed to form the probe card 90. Thereafter, the circuit board 100 is pressurized and thereby is abutted to the upper surface side of the first anisotropic conductive sheet 18, while, in this state, an electrical signal is provided to the inspective circuit board 85 and is sent from the inspective electrodes of the inspective circuit board 85 to electrodes 102 of the circuit board 100. Thereafter, the signal is again returned to the inspective circuit board 85 and thereby the circuit of the circuit board 100 is detected.

Fig. 21 shows an example such that the circuit board 100 of an inspective wafer is disposed on the upper side of the anisotropic conductive connector 10 and the detection is carried out. Of course, the upper and lower sides can be reversed, namely, the circuit board 100 is disposed on the lower side thereof and the detection can be carried out.

In the present invention, since the protrusions for positioning of the first and second anisotropic conductive sheet 18 and 20 are formed simultaneously with the formation of the conductive portions 41 in the molds 50 and 55, the conductive portions 41 and the protrusions for positioning are formed with high positional accuracy at low cost. The markings for positioning in the center substrate 16 are formed simultaneously with the formation of the circuit region and thereby they are also formed with high positional accuracy.

The protrusions for positioning of the anisotropic conductive sheet thus formed with high positional accuracy and the markings for positioning in the center substrate formed with high positional accuracy are positioned. Accordingly, in the anisotropic connector obtainable by the present invention, the anisotropic conductive sheet and the center substrate are positioned with high positional accuracy and thereby the electrical inspection of the circuit boards such as fine and highly dense wafers can be carried out with high inspection accuracy.

The examples of the present invention were described above, however the present invention is not limited by the above-described examples.
For example, in the examples shown by Figs. 1 to 7, the semi-transparent protrusions 3 and the marks 5 for positioning were formed on the metal frame 30 of the anisotropic conductive sheet, and further these protrusions 3 and marks 5 for positioning may be formed inside the anisotropic conductive film 42 in the circuit region A.

In the example shown by Fig. 10, both of the through-holes 70 and the semi-transparent protrusions 71 and 72 are provided on the frame-like portion B of the metal frame 30, and further the through-holes 70 and the semi-transparent protrusions 71 and 72 may be provided on the circuit region A in place of the portion B.

### BRIEF DESCRIPTION OF DRAWING

Fig. 1 (A) is a schematic plan view of an anisotropic conductive sheet in one example according to the present invention.
Fig. 1(B) is a cross section taken on line X-X of Fig. 1(A).
Fig. 2 is an enlarged cross section of the anisotropic conductive sheet shown in Fig. 1.
Fig. 3(A) is a schematic plan view of a center substrate as an object, which is positioned in an anisotropic conductive sheet.
Fig. 3(B) is a cross section taken on line X-X of Fig. 3(A).
Fig. 4 is a schematic cross section of a case that the center substrate shown as an object in Fig. 3 is positioned in the anisotropic conductive sheet shown in Fig. 1.
Fig. 5 (A) and (B) are each a macroscopic plan view shown by a micrograph of a case that fine adjustment is carried out in the positioning of the semi-transparent protrusion and marking shown in Fig. 4.
Fig. 6 is a cross section of a case that the positioning is carried out by forming a through-hole in place of the marking for an object shown in Fig. 4.
Figs. 7 (A), (B) and (C) show another example. Fig. 7(A) is a schematic plane view of an anisotropic conductive sheet having one semi-transparent protrusion formed on each of the upper side portion and the lower side portion. Fig. 7 (B) is a schematic plan view of the center substrate, which is an object for positioning on the anisotropic conductive sheet shown in Fig. 7(A), and a marking is formed on one side portion of the center substrate and a through-hole is formed on other side portion thereof, respectively. Fig. 7(C) is a schematic cross section of a case that the anisotropic conductive sheet shown in Fig. 7 (A) and the center substrate shown in Fig. 7 (B) are positioned.
Fig. 8 is a schematic plan view of an anisotropic conductive connector in one example according to the present invention.
Fig. 9 is an enlarged cross section of an anisotropic conductive connector shown in Fig. 8.
Fig. 10 is a schematic plane view of each constituting element of the anisotropic conductive connector shown in Fig. 8. Fig. 10 (A) is a schematic plane view of the first anisotropic conductive sheet, Fig. 10 (B) is a schematic plane view of the center substrate and Fig. 10 (C) is a schematic plane view of the second anisotropic conductive sheet.
Fig. 11 (A) is a plane view of a frame and Fig. 11 (B) is a cross section of the frame.
Fig. 12 is a cross section of a mold used in the preparation of the first anisotropic conductive sheet or the second anisotropic conductive sheet.
Fig. 13 is a cross section of a condition that a frame is disposed on the mold shown in Fig. 12.
Fig. 14 is a cross section of a case that molding materials are disposed in the mold shown in Fig. 13.
Fig. 15 is a cross section of a case that the mold shown in Fig. 14 is clamped.
Fig. 16 is a cross section of a case that a magnetic field is acted on the mold shown in Fig. 15.
Fig. 17 is a cross section of a case that the first anisotropic conductive sheet or the second anisotropic conductive sheet is taken off from the mold shown in Fig. 16.
Fig. 18 is a cross section taken on line Y-Y of a mechanism of positioning the constituting elements shown in Fig. 10 (A), (B) and (C).
Fig. 19 (A) and (B) each are a macroscopic plan view shown by a micrograph of a case that a semi-transparent protrusion and a marking are finely adjusted for positioning.
Fig. 20 is a cross section showing a mechanism that a three-layered anisotropic conductive connector and an inspective circuit board are positioned.
Fig. 21 is a schematic cross section of a case that a probe card is formed using the anisotropic conductive connector in the example of the present invention and a circuit substrate is inspected using this probe card.
Fig. 22 is a schematic cross section of a case that a conventional anisotropic conductive connector is set in a detecting apparatus. Provided is a method for positioning an anisotropic conductive connector, which method can conduct positioning of each component of a three-layered rectangular frame-like anisotropic conductive connector completely and easily.

### [Means for solving]

The method is a method for positioning a three-layered rectangular frame-like anisotropic conductive connector in order to inspect the electrical properties of an object for inspection. The positioning is carried out in the following manner. The three-layered anisotropic conductive sheet is composed of a first anisotropic conductive sheet 18, a center substrate 16 and a second anisotropic conductive sheet 20. Markings 76 and 77, and through-holes 74, 75 are formed on the center substrate 16, and semi-transparent protrusions 71, 72, 49 and 78, and through-holes 70 and 80 are formed on each of the first anisotropic conductive sheet 18 and the second anisotropic conductive sheet 20. The markings 76 and 77 are identified through the semi-transparent protrusions 71 and 49 by a detecting means 81 and 83 disposed on the side of the first anisotropic conductive sheet 18 and a detecting means 82 disposed on the side of the second anisotropic conductive sheet 20 and thereby the positioning of the semi-transparent protrusions 71 and 49 to the markings 76 and 77 is carried out, whereby performing the positioning of the first anisotropic conductive sheet 18, the center substrate 16 and the second anisotropic conductive sheet 20.

### [Description of Number]

1 ... Anisotropic conductive sheet
3 ... Semi-transparent protrusion
5 ... Mark for alignment
5a ... conductive particles
7 ... Object (center substrate)
8, 76, 77 ... Markings
10, 93 ... Anisotropic conductive connector
11 ... Detecting means
13, 70, 74, 75, 80 ... Through-holes
16 ... Center substrate
18 ... First anisotropic conductive sheet
19 ... Electrifying path
19a ... Upper connecting terminal
19b ... Lower connecting terminal
20 ... Second anisotropic conductive sheet
30 ... Metal frame
40 ... Insulating portion
41 ... Conducting portion
42 ... Anisotropic conductive film
43 ... Another opening
45 ... Elastic film
49 ... First protrusion of the second anisotropic conductive sheet
   A ... Circuit region
   B ... Frame-like portion of a metal frame
   C ... Circuit region of center substrate
   D ... Frame-like portion of center substrate
50 ... Upper mold
51, 56 ... Ferromagnetic substrates
52, 57 ... Ferromagnetic layers
53 ... Non-magnetic layers
54a, 54b ... Spacers
55 ... Lower mold
58 ... Non-magnetic layer
59 ... Molding space
61a, 61b ... Molding material layers
69 ... Closed hole
71 ... First protrusion of the first anisotropic conductive sheet
72 ... Second protrusion of the first anisotropic conductive sheet
73 ... Opening
78 ... Second protrusion of the second anisotropic conductive sheet
81A ... First detecting means
81B ... Second detecting means
82A ... Third detecting means
82B ... Fourth detecting means
83 ... Fifth detecting means
85, 92 ... Circuit boards for inspection
86, 87 ... Markings of circuit board for inspection
88 ... Sixth detecting means
89 ... Seventh detecting means
90 ... Probe card
91, 100 ... Circuit boards
94, 102 ... Electrodes

## Claims

1. In positioning a flexible anisotropic conductive sheet to an object, a method for positioning an anisotropic conductive sheet which method comprises the steps of:
forming a semi-transparent protrusion on the anisotropic conductive sheet and also
forming a marking or a through-hole on the object,
identifying the marking through the semi-transparent protrusion formed on the anisotropic conductive sheet and thereby
positioning the anisotropic conductive sheet to the object.

2. In positioning a flexible anisotropic conductive sheet to an object, a method for positioning an anisotropic conductive sheet which method comprises the steps of:
forming at least two semi-transparent protrusions on the anisotropic conductive sheet and also
forming at least one marking and at least one through-hole on the object,
identifying the marking through the one semi-transparent protrusion formed on the anisotropic conductive sheet and also identifying the through-hole through the other one semi-transparent protrusion and thereby
positioning the anisotropic conductive sheet to the object.

3. The method for positioning an anisotropic conductive sheet according to claim 1 which further comprises previously forming a non-transparent mark for alignment in the periphery of the semi-transparent protrusion formed on the anisotropic conductive sheet,
wherein the positioning of the anisotropic conductive sheet and the object is conducted by, at first, approaching the mark for alignment to the marking or through-hole formed on the object, and then aligning the semi-transparent protrusion to the marking or through-hole center and thereby conducting fine adjustment for positioning.

4. The method for positioning an anisotropic conductive sheet according to claim 2 which further comprises previously forming a non-transparent mark for alignment in the periphery of the two semi-transparent protrusions formed on the anisotropic conductive sheet,
wherein the positioning of the anisotropic conductive sheet and the object is conducted by, at first, approaching the mark for alignment formed in the periphery of the one semi-transparent protrusion to the marking formed on the object and also approaching the mark for alignment formed in the periphery of the other semi-transparent protrusion to the through-hole, and then aligning the one semi-transparent protrusion to the marking center and also aligning the other semi-transparent protrusion to the through-hole center, and thereby conducting fine adjustment for positioning.

5. The method for positioning an anisotropic conductive sheet according to any one of the preceding claims wherein the marking or the through-hole formed on the object is simultaneously formed in a process of forming a circuit on the object.

6. The method for positioning an anisotropic conductive sheet according to any one of claims 1 to 5 wherein the positioning of the anisotropic conductive sheet and the object is conducted on two sides or two sets of two sides which are parallel each other.

7. The method for positioning an anisotropic conductive sheet according to any one of claims 1 to 6 wherein the object is a hard center substrate.

8. A method for positioning an anisotropic conductive connecter obtainable by disposing a first anisotropic conductive sheet, a center substrate and a second anisotropic conductive sheet in this order, which method comprises the steps of:
forming a semi-transparent protrusion on each of the first anisotropic conductive sheet and the second anisotropic conductive sheet,
forming a marking on each of the upper and lower surfaces of the center substrate,
identifying the markings formed on the center substrate through the semi-transparent protrusions formed on the first and second anisotropic conductive sheets from the both sides by a detecting means disposed on the first anisotropic conductive sheet side and a detecting means disposed on the second anisotropic conductive sheet side, and thereby
conducting positioning of the first anisotropic conductive sheet, the center substrate and the second anisotropic conductive sheet.

9. The method for positioning an anisotropic conductive connecter according to claim 8 which further comprises forming a non-transparent mark for alignment in the periphery of the semi-transparent protrusion formed on each of the first and second anisotropic conductive sheets respectively,
wherein the identification of the markings formed on the upper and lower surfaces of the center substrate through the semi-transparent protrusions of the first and second anisotropic conductive sheets is conducted by, at first, identifying that the non-transparent marks for alignment are set to be opposite to the markings and then aligning the semi-transparent protrusions to the marking centers and thereby conducting fine adjustment for positioning.

10. The method for positioning an anisotropic conductive connecter according to claim 8 or 9 wherein the positioning of the first anisotropic conductive sheet, the center substrate and the second anisotropic conductive sheet is conducted on two sides or two sets of two sides which are parallel each other.

11. The method for positioning an anisotropic conductive connecter according to claim 8 or 9 which further comprises forming at least two semi-transparent protrusions and at least one through-hole in each of four sides of the first anisotropic conductive sheet and in each of four sides of the second anisotropic conductive sheet, respectively and also forming at least two through-holes in each of four sides of the center substrate and at least one marking on each of the upper and lower surfaces of the center substrate,
wherein the positioning of the first anisotropic conductive sheet and the center substrate is conducted by aligning the one semi-transparent protrusion formed on the first anisotropic conductive sheet to the one through-hole formed on the center substrate and also aligning the other one semi-transparent protrusion formed on the first anisotropic conductive sheet to the upper surface marking formed on the center substrate, and the positioning of the second anisotropic conductive sheet and the center substrate is conducted by aligning the one semi-transparent protrusion formed on the second anisotropic conductive sheet to the one through-hole formed on the center substrate and also aligning the other one semi-transparent protrusion formed on the second anisotropic conductive sheet to the lower surface marking formed on the center substrate.

12. In positioning, on a circuit board for inspection, a rectangular anisotropic conductive connector having a three-layered structure obtainable by aligning a first anisotropic conductive sheet having at least two semi-transparent protrusions and at least one through-hole formed on each side of four sides of the rectangular frame-like form, a second anisotropic conductive sheet having at least two semi-transparent protrusions and at least one through-hole formed on each side of four sides of the rectangular frame-like form, and a center substrate having at least two through-holes formed on each side of four sides of the rectangular frame-like form and at least one marking formed on each of the upper and lower surfaces, and thereby making one piece,
a method for positioning an anisotropic conductive connector and a circuit board for inspection, which method comprises the steps of:
forming at least two markings on each side of four sides of a rectangular frame-like form of the circuit board for inspection,
aligning the one semi-transparent protrusion of either of the first anisotropic conductive sheet and the second anisotropic conductive sheet, which protrusion corresponds to the one through-hole on one side of the four sides of the center substrate, to the one marking of the circuit board for inspection, and further,
aligning the other semi-transparent protrusion of either of the first anisotropic conductive sheet and the second anisotropic conductive sheet, which protrusion corresponds to the other one through-hole on one side of the four sides of the center substrate, to the other one marking of the circuit board for inspection and thereby
conducting positioning on each side of the four sides respectively.

13. An anisotropic conductive connector having a rectangular frame-like form and a three-layered structure, obtainable by disposing a first anisotropic conductive sheet having a semi-transparent protrusion and a through-hole, a center substrate having a marking and a though-hole, and a second anisotropic conductive sheet having a semi-transparent protrusion and a through-hole, in this order
wherein the positioning of the center substrate, the first anisotropic conductive sheet and the second anisotropic conductive sheet are conducted by aligning the semi-transparent protrusion of the first anisotropic conductive sheet and the marking of the center substrate, and aligning the semi-transparent protrusion of the second anisotropic conductive sheet and the marking.

14. The anisotropic conductive connector according to claim 13
wherein the marking and the though-hole formed on the center substrate are formed simultaneously in a process of forming a circuit on the center substrate.

15. A probe card comprising a rectangular frame-like anisotropic conductive connector having a three-layered structure formed in one piece as claimed in claim 13 and a circuit board for inspection.

16. A probe card comprising:
a rectangular frame-like anisotropic conductive connector having a three-layered structure formed in one piece, obtainable by disposing a first anisotropic conductive sheet having a semi-transparent protrusion and a through-hole, a center substrate having a marking and a though-hole and a second anisotropic conductive sheet having a semi-transparent protrusion and a through-hole, in this order, and
a circuit board having a marking for inspection,
wherein the positioning of the anisotropic conductive connector having a three-layered structure and the circuit board for inspection is conducted by positioning the semi-transparent protrusion formed on the first or second anisotropic conductive sheet to the marking formed on the circuit board for inspection, and also positioning the other semi-transparent protrusion formed on the first or second anisotropic conductive sheet to the marking formed on the circuit board for inspection.

17. An anisotropic conductive sheet comprising:
an anisotropic conductive film having a conductive part, which film is disposed inside of an opening of a metal frame,
a semi-transparent protrusion disposed on an opening different from the opening of the metal frame on which the anisotropic conductive film is disposed, and
an elastic film having a non-transparent mark for alignment which film is disposed in the periphery of the semi-transparent protrusion.

18. An anisotropic conductive sheet comprising an anisotropic conductive film having a conductive part, which film is disposed inside of an opening of a metal frame wherein the anisotropic conductive film has a semi-transparent protrusion and a non-transparent mark for alignment disposed in the periphery of the semi-transparent protrusion.
